Europäisches Patentamt

European Patent Office

Office européen des brevets

(19)

(11) Veröffentlichungsnummer: **0 250 769**
**A2**

(12) **EUROPÄISCHE PATENTANMELDUNG**

(21) Anmeldenummer: **87106347.5**

(22) Anmeldetag: **02.05.87**

(51) Int. Cl.⁴: **C30B 19/06**

(30) Priorität: **23.05.86 DE 3617404**

(43) Veröffentlichungstag der Anmeldung:
**07.01.88 Patentblatt 88/01**

(84) Benannte Vertragsstaaten:
**DE FR GB IT**

(71) Anmelder: **TELEFUNKEN electronic GmbH**
**Theresienstrasse 2**
**D-7100 Heilbronn(DE)**

(72) Erfinder: **Geibel, Christoph, Dr.**
**Falltorstrasse 39**
**D-7107 Neckarsulm 5(DE)**
Erfinder: **Zimmermann, Harald, Dr.**
**Karwendelstrasse 66**
**D-8017 Ebersberg(DE)**
Erfinder: **Maier, Horst, Dr.**
**Baltenstrasse 14**
**D-7100 Heilbronn(DE)**

(74) Vertreter: **Maute, Hans-Jürgen, Dipl.-Ing.**
**TELEFUNKEN electronic GmbH**
**Theresienstrasse 2**
**D-7100 Heilbronn(DE)**

(54) **Verfahren zum epitaktischen Abscheiden dünner einkristalliner Halbleiterschichten aus pseudobinärem Halbleitermaterial auf einem einkristallinen Substrat.**

(57) Die Erfindung betrifft ein Verfahren zum epitaktischen Abscheiden von pseudobinären Halbleiterschichten auf einem einkristallinen Substrat. Die Erfindung besteht darin, daß das Substrat in eine die Komponenten der abzuscheidenden Schicht enthaltende Lösung eingetaucht wird, wobei diese Lösung zumindest vor dem Eintauchen des Substrats durchmischt wird.

FIG 1

### Verfahren zum epitaktischen Abscheiden dünner einkristalliner Halbleiterschichten aus pseudobinärem Halbleitermaterial auf einem einkristallinen Substrat

Pseudobinäre Halbleitermaterialien weisen oft Phasendiagramme auf, die ein homogenes, einkristallines Wachstum von Volumenkristallen aus der Schmelze oder von epitaktischen Schichten aus der Lösung erschweren. Wenn dazu noch größere Unterschiede in den Atom-oder Molekulargewichten der Schmelz-oder Lösungskomponenten kommen, ist ein homogenes Wachstum aus der flüssigen Phase ohne zusätzliche Maßnahmen unmöglich. Dies ist zum Beispiel bei $Hg_{1-x}Cd_xTe$ der Fall, einem Material, dem heute in der Halbleiterbauelementetechnik für Infrarotsensoren große Bedeutung zukommt.

Man hilft sich bei der Herstellung von Volumenkristallen in der Weise, daß man gut durchmischte Schmelzen sehr schnell abkühlt und den entstanden polykristallinen Materialbarren sehr lange Zeit erhitzt. Während dieser Erhitzung findet ein Rekristallisationsprozeß statt, der bei geeigneter Durchführung zu einem Einkristall führt.

Bei der Epitaxie aus der flüssigen Phase verwendet man vorzugsweise eine Tellur-reiche Lösung, die man nach unterschiedlichen Techniken auf einem Substrat in einer dünnen, flüssigen Schicht ausbreitet und aus der die gewünschte Epitaxieschicht durch Abkühlen des Systems abgeschieden wird. Die horizontale Anordnung und die geringe Dicke der Lösung gewährleisten dabei eine einigermaßen ausreichende Homogenität.

Von technischen Gesichtspunkten ausgehend, wäre für die Epitaxie ein Eintauchen eines Substrats in eine Lösung wünschenswert. Hier tritt jedoch die Schwierigkeit der ungenügenden Durchmischung und der Gravitationsentmischung auf. Im Falle des $Hg_{1-x}Cd_xTe$ führt dies zu unterschiedlichen Zusammensetzungen und zu unterschiedlichen Dicken der abgeschiedenen Epitaxieschicht, gemessen über deren Oberfläche. Da große epitaktische Schichtflächen angestrebt werden, können solche Inhomogenitäten nicht akzeptiert werden.

Der Erfindung liegt die Aufgabe zugrunde, ein epitaktisches Abscheidungsverfahren für Halbleiterschichten aus pseudobinärem Halbleitermaterial anzugeben, mit dem sehr homogene Schichten großer Fläche erzeugt werden können. Diese Aufgabe wird erfindungsgemäß dadurch gelöst, daß das Substrat für eine vorgegebene Zeit in eine die Komponenten der Schicht enthaltende Lösung getaucht wird, wobei sich die Schicht während dieses Zeitraums bei konstanter oder fallender Temperatur abscheidet und daß die Lösung zumindest unmittelbar vor dem Eintauchen des Substrats durchmischt wird.

Bei einer Weiterbildung des erfindungsgemäßen Verfahrens wird die Lösung zusätzlich auch während der Schichtabscheidung durchmischt, wobei unterschiedliche Durchmischungsverfahren angewendet werden können. Die abzuscheidende Epitaxieschicht besteht vorzugsweise aus $Hg_{1-x}Cd_xTe$ bei einem Substrat, das im Hinblick auf sei ne Gitterstruktur auf $Hg_{1-x}Cd_xTe$ und im Hinblick auf seine optischen und elektrischen Eigenschaften auf das angestrebte Bauelement abgestimmt ist.

Der vorliegenden Erfindung liegt die Erkenntnis zugrunde, daß für die Inhomogenitäten in abgeschiedenen Epitaxieschichten bestimmte Faktoren verantwortlich sind. So wird inhomogenes Quellmaterial in Tellur nicht gleichmäßig gelöst. Cadmiumtellurid oder cadmiumreiches $Hg_{1-x}Cd_xTe$ hat eine höhere Liquidustemperatur als Quecksilbertellurid oder Hg-reiches $Hg_{1-x}Cd_xTe$. Um eine Lösung mehrmals für die Tauchepitaxie nach der Erfindung verwenden zu können, werden Cadmiumtellurid und Quecksilbertellurid in dem Maße, wie es auf den Substraten abgeschieden wird, in die Lösung nachgewogen. Diese Zugaben in Form von polykristallinem Material lösen sich im nachfolgenden Epitaxiedurchgang allerdings nur schwer auf. Ein weiterer Grund für Inhomogenitäten ergibt sich daraus, daß Cadmiumtellurid oder cadmiumreiches $Hg_{1-x}Cd_x$ Te aus der Lösung leichter ausfällt als Quecksilbertellurid oder quecksilberreiches $Hg_{1-x}Cd_xTe$. In der Lösung tritt somit, wenn nicht besondere Maßnahmen ergriffen werden, eine Schichtung von quecksilberreichen und cadmiumreichen Anteilen auf.

Durch diese kritischen Prozesse ausgelöste inhomogenitäten in abgeschiedenen Epitaxieschichten werden nach der Erfindung dadurch verhindert, daß die Lösung zumindest unmittelbar vor der epitaktischen Schichtabscheidung gut durchmischt wird. Diese Durchmischung kann aber auch während des Abscheidungsprozesses der epitaktischen Halbleiterschichten fortgesetzt werden. Eine Durchmischung erfolgt vorzugsweise durch Schwenken des gesamten Reaktors um eine senkrecht zu seiner Längsachse verlaufende Achse. Ferner kann der Reaktor bzw. der Teil, der den Lösungstiegel enthält, um die Längsachse des Reaktors rotieren, wobei durch einen Wechsel des Drehsinns und durch eine Veränderung der Beschleunigung, die Durchmischung der Lösung verbessert wird. Eine weitere Möglichkeit ergibt sich durch die Anwendung des sogenannten magnetischen Rührens. Hierbei wirkt auf die Lösung ein Wechsel-bzw. Drehfeld ein, durch das die Lösung in Bewegung gesetzt und vermischt wird. Diese Durchmischungsverfahren sind bei der Herstellung von Volumenkristallen bekannt und werden dort auch erfolgreich eingesetzt. Die hier erstmals vorgestellte Kombination von Flüssigphasenepitaxie nach dem Tauchprinzip und diesen Durchmischungstechniken bewirken eine wesentliche Erweiterung der Epitaxie und ihrer Anwendungen.

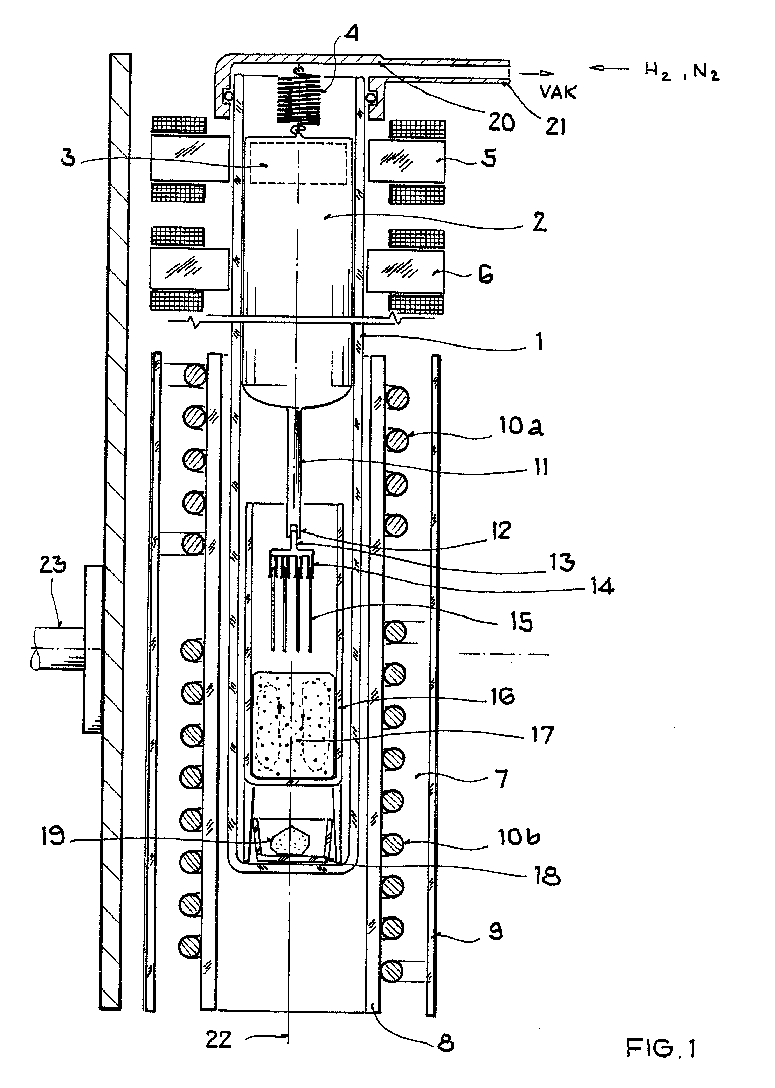

Das erfindungsgemäße Verfahren soll nachstehend noch anhand von Ausführungsbeispielen näher erläutert werden. In der Figur 1 ist im Schnitt ein Reaktor dargestellt, der für die epitaktische Schichtabscheidung im Tauchverfahren geeignet ist. Der Reaktor R besteht aus einem ersten Quarzrohr 1, das mit einem abnehmbaren Kopf 20 verschlossen ist. Dieser Kopf ist mit einem Gasanschluß 21 versehen, über den das System abgepumpt bzw. mit Wasserstoff oder Stickstoff geflutet werden kann. In dem Glasrohr 1 ist ein zweites Rohr 2 angeordnet, wobei dieses zweite Rohr so dicht im ersten Rohr 1 geführt ist, daß aus dem Tiegel 16 abdampfendes Quecksilber kondensiert und zurückfließt.

Dieses Rohr 2 weist am unteren Ende eine als Substrathalter ausgebildete Verjüngung 11 auf. In diese stan gen-oder rohrförmig ausgebildete Verjüngung ist am äußersten Ende ein Schlitz 12 eingebracht, in dem ein kammförmig ausgebildeter Substrathalter 13 durch Klemmwirkung gehaltert wird. Die Enden der Zähne 14 dieses kammartigen Halters sind wiederum geschlitzt, so daß in diese Schlitze die Substratscheiben 15 eingefügt werden können. Wie aus der Figur ersichtlich, können mit dem kammartigen Halter 13 mehrere parallel zueinander angeordnete Substratscheiben in die Lösung 17 im Tiegel 16 abgesenkt werden.

Das Rohr 2 enthält einen Eisenkern 3, auf den außen angebrachte Magnete 5 und 6 einwirken. Bei der Aktivierung des Magnetes 6 wird das Rohr 2 abgesenkt, so daß die Substratscheiben 15 in die Lösung 17 aus Cadmiumquecksilbertellurid im Tiegel 16 abgesenkt werden. Bei Aktivierung des Magneten 5 werden die Substrate aus der Lösung 17 entfernt. Die Rückholfeder 4 am Rohr 2 haltert das Rohr 2 in der Ruheposition. Der Tiegel 16 ist etwa nur zu einem Drittel mit der Lösung 17 gefüllt, so daß beim Schwenken oder Rotieren dieses Behälters die Lösung nicht aus dem Tiegel austreten kann. Unter dem Tiegel 16 ist noch ein kleinerer Tiegel 18 angeordnet, der eine Quecksilbertelluridquelle 19 enthält, die für einen konstanten Quecksilberdampfdruck im Reaktor sorgt.

Um den Tiegelbereich ist ein Ofen 7 angeordnet, der vorzugsweise aus zwei getrennt steuerbaren Teilen besteht. Es handelt sich um einen semitransparenten Ofen mit einem Träger 8, auf der die Heizspulen angeordnet sind und einem außenliegenden Reflektor 9, durch den Wärmeverluste weitgehend vermieden werden. Die Heizwicklung 10b beeinflußt im wesentlichen den Bereich des die Lö sung enthaltenden Tiegels 16 und der Quecksilbertelluridquelle 19. Die obere Heizwicklung 10a wirkt im wesentlichen auf die Substratscheiben im nicht eingetauchten Zustand ein. Der Gesamtreaktor R kann um eine Achse 23, die senkrecht zu der Längsachse 22 durch den Reaktor verläuft, geschwenkt werden, so daß die im Tiegel 16 befindliche Lösung 17 durch diesen Schwenkprozeß durchmischt wird. Es ist eine beidseitige Auslenkung aus der senkrechten Ruhelage oder auch nur eine einseitige Auslenkung aus der Ruhelage denkbar. Es hat sich gezeigt, daß durch diese Auslenkprozesse die Lösung 17 im Tiegel 16 sehr gut durchmischt wird, so daß bei einem epitaktischen Abscheidungsprozeß, der unmittelbar nach der Durchmischung durchgeführt wird, sehr homogene Epitaxieschichten mit Dicken zwischen 10 und 100 μm dotiert oder undotiert auf relativ großen Substratflächen abgeschieden werden konnten. Bei der epitaktischen Abscheidung liegt die Lösungstemperatur bei 450 bis 500 °C.

Es hat sich auch als vorteilhaft erwiesen, wenn der Schwenkprozeß auch während des Abscheideverfahrens weiter fortgesetzt wird, da auf diese Weise eine Entmischung sicher verhindert wird. Bei der dargestellten Ausführungsform verläuft die Strömungsrichtung der geschwenkten Lösung im wesentlichen parallel zu den Substratscheiben 15.

Eine andere Methode zur Durchmischung der Lösung 17 im Tiegel 16 besteht in der Rotation des Gesamtreaktors R bzw. des Tiegels 16 um die Vertikalachse 22 der dargestellten Vorrichtung. Hierbei wird vorzugsweise der Drehsinn der Rotation ständig gewechselt und die Beschleunigung verändert, so daß eine gute Durchmischung der Lösung 17 erfolgt.

Ferner besteht die Möglichkeit, nur die Haltevorrichtung 13 zusammen mit den gehaltenen Substratscheiben im eingetauchten Zustand zu drehen, um auf diese Weise eine stetige Durchmischung der Lösung während des epitaktischen Abscheidungsvorganges sicherzustellen. Das Glasrohr 2 kann durch Einwirken eines Drehfeldes in Bewegung versetzt werden.

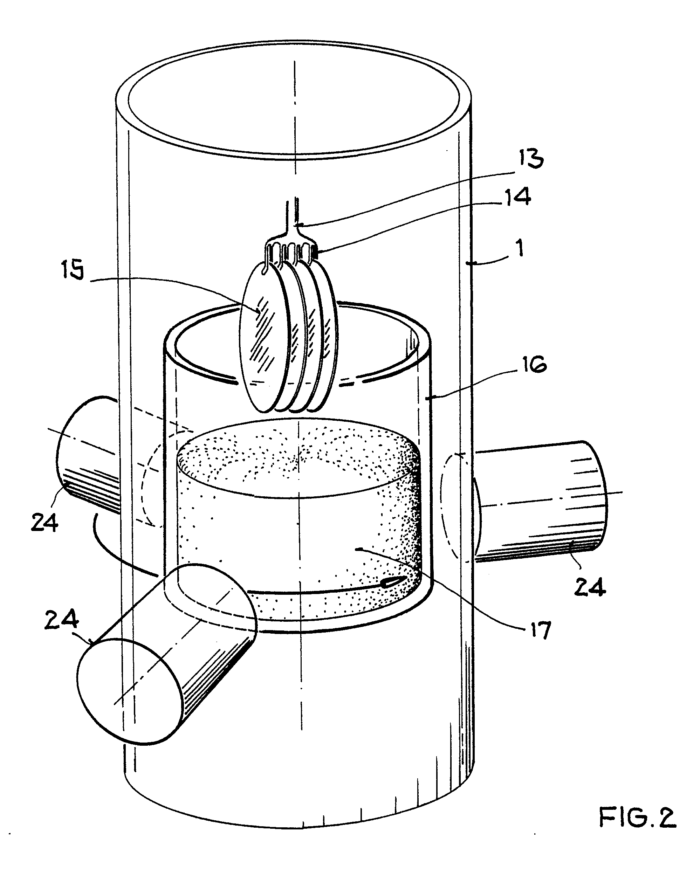

Gemäß Figur 2 besteht auch die Möglichkeit, die Lösung 17 im Tiegel 16 durch Einwirken eines Drehfeldes zu durchmischen. Hierzu werden beispielsweise drei jeweils um 120 Grad versetzte Spulen 24 an der Außenseite des Tiegels 16 angeordnet, mit denen beispielsweise ein 150 kHz Drehfeld erzeugt wird. Durch die Einwirkung dieses Drehfelds wird die Lösung 17 in Bewegung gesetzt und durchmischt.

**Ansprüche**

1) Verfahren zum epitaktischen Abscheiden dünner einkristalliner Halbleiterschichten aus pseudobinärem Halbleitermaterial auf einem einkristallinen Substrat, dadurch gekennzeichnet, daß das Substrat (15) in eine, die Komponenten der Schicht enthaltende Lösung (17) getaucht wird, wobei sich die Schicht während dieses Zeitraums bei konstanter oder fallender Temperatur abscheidet und daß die Lösung zumindest unmittelbar vor dem Eintauchen des Substrats durchmischt wird.

2) Verfahren nach Anspruch 1, dadurch gekennzeichnet, daß die Lösung zusätzlich auch während der Schichtabscheidung durchmischt wird.

3) Verfahren nach dem Anspruch 1 oder 2, dadurch gekennzeichnet, daß die Halbleiterschicht aus $Hg_{1-x}Cd_xTe$ besteht.

4) Verfahren nach einem der vorangehenden Ansprüche, dadurch gekennzeichnet, daß für den Abscheidungsprozeß ein nahezu geschlossenes Reaktorrohrsystem (R) aus zwei dicht ineinanderpassenden Rohren (1, 2) verwendet wird, indem sich ein Tiegel (16) mit der Lösung (17) sowie eine Vorrichtung (2, 3, 4, 5, 6) zum Eintauchen von ein oder mehreren Substraten (15) in die Lösung befindet.

5) Verfahren nach einem der vorangehenden Ansprüche, dadurch gekennzeichnet, daß das Reaktorrohrsystem (R) oder Teile desselben mit dem die Lösung (17) enthaltenden Tiegel (16) periodisch um eine Achse (23) geschwenkt wird, die senkrecht zur Rohrachse (22) steht.

6) Verfahren nach einem der Ansprüche 1 bis 4, dadurch gekennzeichnet, daß das Reaktorrohrsystem oder Teile desselben mit dem die Lösung (17) enthaltenden Tiegel (16) in ungleichmäßiger Bewegung um die Rohrachse (22) gedreht werden.

7) Verfahren nach einem der Ansprüche 1 bis 4, dadurch gekennzeichnet, daß die Lösung (17) im Tiegel (16) durch ein außen anliegendes magnetisches Dreh-oder Wechselfeld (B) durchmischt wird.

8) Verfahren nach Anspruch 5, dadurch gekennzeichnet, daß der Tiegel (16) in eine Pendelbewegung versetzt wird, wobei die durch die Schwenkung erzeugte Strömungsrichtung der Lösung parallel zur Substratoberfläche verläuft.

9) Verfahren nach Anspruch 6, dadurch gekennzeichnet, daß der Tiegel (16) in Rotation mit wechselnder Drehrichtung und veränderter Beschleunigung versetzt wird.

10) Verfahren nach einem der vorangehenden Ansprüche, gekennzeichnet durch die Verwendung zur Abscheidung von 10 - 100 μm dicken HgCdTe-Epitaxieschichten.

FIG.1

FIG.2